# EUROPEAN PATENT APPLICATION

(11) **EP 4 648 097 A1**
(43) Date of publication of application: **12.11.2025**
(21) Application number: 24180395.6
(22) Date of filing: 06.06.2024
(51) Int. Cl.: H01L 23/367, H01L 23/373, G06F 1/20

(54) **HEAT MANAGEMENT SYSTEM COMPRISING DIAMOND PARTICLES**

(30) Priority: 07.05.2024 US 202418656827
(71) Applicant: II-VI Delaware, Inc., Wilmington, Delaware 19801 (US)
(72) Inventor: Wang, Jiwen, Glastonbury, 06033 (US); Coppola, Jonathan, Ansonia, 06418 (US); Coombs, Nicholas, Cheshire, 06410 (US); Aghajanian, Michael, Newark, 19711 (US)
(74) Representative: Forresters IP LLP

(57) **Abstract**

The present disclosure is directed to a heat management system that includes a ceramic body and a material having a higher thermal conductivity than the ceramic body, the material including a plurality of diamond particles. The material is arranged in a network of channels defined in a surface of the ceramic body and/or forms an extension component attached to the ceramic body.

## Description

### BACKGROUND

### 1. Field

This disclosed subject matter relates generally to heat management systems, methods of manufacturing heat management systems, and computing devices including heat management systems.

### 2. Technical Considerations

Certain devices, such as those used in electronics and/or laser systems, generate heat when in use. Dissipating at least a portion of the heat generated by these devices is a challenge, and failure to adequately manage the heat can make the device dangerous to use and/or impair the devices ability to continue to function properly.

### SUMMARY

Accordingly, it is an object of the presently disclosed subject matter to provide a heat management system that overcomes some or all of the deficiencies identified above.

According to non-limiting embodiments or aspects, provided is a heat management system, including: a ceramic body; and a material having a higher thermal conductivity than the ceramic body and including a plurality of diamond particles, the material arranged in a network of channels defined in a surface of the ceramic body and/or forming an extension component attached to the ceramic body.

In some non-limiting embodiments or aspects, the ceramic body may include a silicon carbide and/or a boron carbide body.

In some non-limiting embodiments or aspects, the material may include a reaction-bonded silicon carbide and/or boron carbide composition at least partially surrounding the diamond particles.

In some non-limiting embodiments or aspects, silicon and/or boron may be reacted with the diamond particles to form a SiC or B₄C interface.

In some non-limiting embodiments or aspects, the material may further include elemental silicon and/or boron.

In some non-limiting embodiments or aspects, the diamond particles may have an average particle size ranging from 10-150 µm.

In some non-limiting embodiments or aspects, the diamond particles may include 35-70 vol% of the material.

In some non-limiting embodiments or aspects, the material may include a thermal conductivity of at least 400 W/mK.

In some non-limiting embodiments or aspects, the material may include a thermal expansion coefficient (CTE) ranging from 1.0 to 3.0 ppm/K.

In some non-limiting embodiments or aspects, an arrangement of the network of channels and/or the extension component may be selected to transfer heat encountered by the heat management system in a predetermined direction parallel to the surface.

In some non-limiting embodiments or aspects, a depth of the network of channels and/or an arrangement of the extension component may be selected to transfer heat encountered by the heat management system in a predetermined direction perpendicular to the surface.

In some non-limiting embodiments or aspects, an amount of the diamond particles in the material by vol% may vary along the network of channels and/or the extension component.

In some non-limiting embodiments or aspects, the heat management system may further include a component that generates heat proximately arranged relative to the ceramic body, where the ceramic body may include a first region closer to the component than a second region of the ceramic body, where the first region may include a higher concentration of the material compared to the second region.

In some non-limiting embodiments or aspects, the heat management system may further include a component that generates heat proximately arranged relative to the ceramic body, where the ceramic body may include a first region closer to the component than a second region of the ceramic body, where the second region may be a predetermined region to which heat generated by the component is to be transferred, where a channel of the network of channels may include the material and/or the extension component having the material runs from the first region to the second region.

In some non-limiting embodiments or aspects, the heat management system may further include a component that generates heat proximately arranged relative to the ceramic body, where the component may include a component of a computing device.

In some non-limiting embodiments or aspects, the network of channels may be arranged in the ceramic body and have the material therein and/or the extension component having the material may be arranged such that heat from a point heat source applied to a point along the ceramic body is transferred across the surface of the ceramic body faster compared to the same ceramic body not including the network of channels including the material and/or the extension component having the material.

In some non-limiting embodiments or aspects, the heat management system may further include a cooling system, where a channel of the network of channels and/or the extension component may transfer heat to the cooling system.

According to non-limiting embodiments or aspects, also provided is a method of manufacturing a heat management system, the method including: defining a network of channels in a surface of a ceramic body and/or attaching an extension component to the ceramic body; arranging a material having a higher thermal conductivity than the ceramic body in the network of channels and/or the extension component is formed from the material, the material including a plurality of diamond particles.

In some non-limiting embodiments or aspects, the method may further include reaction bonding the material in the network of channels and/or to form the extension component.

In some non-limiting embodiments or aspects, the material may include silicon carbide and/or boron carbide compositions at least partially surrounding the diamond particles, and the reaction bonding the material may include treating the material such that silicon and/or boron reacts with the diamond particles to form a SiC or B₄C interface.

According to non-limiting embodiments or aspects, also provided is a computing device including the heat management system as described herein.

Further embodiments or aspects are set forth in the following numbered clauses:
Clause 1: A heat management system, comprising: a ceramic body; and a material having a higher thermal conductivity than the ceramic body and comprising a plurality of diamond particles, the material arranged in a network of channels defined in a surface of the ceramic body and/or forming an extension component attached to the ceramic body.
Clause 2: The heat management system of clause 1, wherein the ceramic body comprises a silicon carbide and/or a boron carbide body.
Clause 3: The heat management system of clause 1 or 2, wherein the material comprises a reaction-bonded silicon carbide and/or boron carbide composition at least partially surrounding the diamond particles.
Clause 4: The heat management system of clause 3, wherein silicon and/or boron is reacted with the diamond particles to form a SiC or B₄C interface.
Clause 5: The heat management system of clause 3 or 4, wherein the material further comprises elemental silicon and/or boron.
Clause 6: The heat management system of any of clauses 1-5, wherein the diamond particles have an average particle size ranging from 10-150 µm.
Clause 7: The heat management system of any of clauses 1-6, wherein the diamond particles comprise 35-70 vol% of the material.
Clause 8: The heat management system of any of clauses 1-7, wherein the material comprises a thermal conductivity of at least 400 W/mK.
Clause 9: The heat management system of any of clauses 1-8, wherein the material comprises a thermal expansion coefficient (CTE) ranging from 1.0 to 3.0 ppm/K.
Clause 10: The heat management system of any of clauses 1-9, wherein an arrangement of the network of channels and/or the extension component is selected to transfer heat encountered by the heat management system in a predetermined direction parallel to the surface.
Clause 11: The heat management system of any of clauses 1-10, wherein a depth of the network of channels and/or an arrangement of the extension component is selected to transfer heat encountered by the heat management system in a predetermined direction perpendicular to the surface.
Clause 12: The heat management system of any of clauses 1-11, wherein an amount of the diamond particles in the material by vol% varies along the network of channels and/or the extension component.
Clause 13: The heat management system of any of clauses 1-12, further comprising a component that generates heat proximately arranged relative to the ceramic body, wherein the ceramic body comprises a first region closer to the component than a second region of the ceramic body, wherein the first region comprises a higher concentration of the material compared to the second region.
Clause 14: The heat management system of any of clauses 1-13, comprising a component that generates heat proximately arranged relative to the ceramic body, wherein the ceramic body comprises a first region closer to the component than a second region of the ceramic body, wherein the second region is a predetermined region to which heat generated by the component is to be transferred, wherein a channel of the network of channels comprising the material and/or the extension component having the material runs from the first region to the second region.
Clause 15: The heat management system of any of clauses 1-14, further comprising a component that generates heat proximately arranged relative to the ceramic body, wherein the component comprises a component of a computing device.
Clause 16: The heat management system of any of clauses 1-15, wherein the network of channels are arranged in the ceramic body and have the material therein and/or the extension component having the material is arranged such that heat from a point heat source applied to a point along the ceramic body is transferred across the surface of the ceramic body faster compared to the same ceramic body not comprising the network of channels comprising the material and/or the extension component having the material.
Clause 17: The heat management system of any of clauses 1-16, further comprising: a cooling system, wherein a channel of the network of channels and/or the extension component transfers heat to the cooling system.
Clause 18: A method of manufacturing a heat management system, comprising: defining a network of channels in a surface of a ceramic body and/or attaching an extension component to the ceramic body; arranging a material having a higher thermal conductivity than the ceramic body in the network of channels and/or the extension component is formed from the material, the material comprising a plurality of diamond particles.
Clause 19: The method of clause 18, further comprising: reaction bonding the material in the network of channels and/or to form the extension component.
Clause 20: The method of clause 19, wherein the material comprises silicon carbide and/or boron carbide compositions at least partially surrounding the diamond particles, and the reaction bonding the material comprises treating the material such that silicon and/or boron reacts with the diamond particles to form a SiC or B₄C interface.
Clause 21: A computing device comprising the heat management system of any of clauses 1-17.
Clause 22: Use of a heat management system of any of clauses 1-17 for dissipating heat generated by a heat-generating device.
Clause 23: The use of clause 22, wherein the heat-generating device comprises a computing device.
Clause 24: A method for dissipating heat of a heat-generating device, comprising placing the heat-generating device in contact with a heat management system of any of clauses 1-17.
Clause 25: The method of clause 24, wherein the heat-generating device comprises a computing device.

These and other features and characteristics of the presently disclosed subject matter, as well as the methods of operation and functions of the related elements of structures and the combination of parts and economies of manufacture, will become more apparent upon consideration of the following description and the appended claims with reference to the accompanying drawings, all of which form a part of this specification, wherein like reference numerals designate corresponding parts in the various figures. It is to be expressly understood, however, that the drawings are for the purpose of illustration and description only and are not intended as a definition of the limits of the disclosed subject matter. As used in the specification and the claims, the singular forms of "a," "an," and "the" include plural referents unless the context clearly dictates otherwise.

### BRIEF DESCRIPTION OF THE DRAWINGS

Additional advantages and details of the disclosed subject matter are explained in greater detail below with reference to the exemplary embodiments or aspects that are illustrated in the accompanying figures, in which:
FIGS. 1A-1H show perspective views of ceramic bodies being formed into a heat management system according to some non-limiting embodiments or aspects of the presently disclosed subject matter;
FIG. 2 shows a schematic diagram of a heat management system according to some non-limiting embodiments or aspects of the presently disclosed subject matter;
FIG. 3 shows a cross-sectional microscopic image of a heat management system according to some non-limiting embodiments or aspects of the presently disclosed subject matter;
FIGS. 4A-4B show schematic diagrams of a preform (FIG. 4A) and reaction bonded (FIG. 4B) material according to some non-limiting embodiments or aspects of the presently disclosed subject matter;
FIGS. 5A-5B show infrared images of a heat management system according to some non-limiting embodiments or aspects of the presently disclosed subject matter; and
FIGS. 6A-6B show infrared images of a comparative heat management system and a heat management system according to some non-limiting embodiments or aspects of the presently disclosed subject matter.

### DESCRIPTION

For purposes of the description hereinafter, the terms "end," "upper," "lower," "right," "left," "vertical," "horizontal," "top," "bottom," "lateral," "longitudinal," and derivatives thereof shall relate to the disclosed subject matter as it is oriented in the drawing figures. However, it is to be understood that the disclosed subject matter may assume various alternative variations and step sequences, except where expressly specified to the contrary. It is also to be understood that the specific devices and processes illustrated in the attached drawings, and described in the following specification, are simply exemplary embodiments or aspects of the disclosed subject matter. Hence, specific dimensions and other physical characteristics related to the embodiments or aspects disclosed herein are not to be considered as limiting unless otherwise indicated.

No aspect, component, element, structure, act, step, function, instruction, and/or the like used herein should be construed as critical or essential unless explicitly described as such. Also, as used herein, the articles "a" and "an" are intended to include one or more items and may be used interchangeably with "one or more" and "at least one." Furthermore, as used herein, the term "set" is intended to include one or more items (e.g., related items, unrelated items, a combination of related and unrelated items, and/or the like) and may be used interchangeably with "one or more" or "at least one." Where only one item is intended, the term "one" or similar language is used. Also, as used herein, the terms "has," "have," "having," or the like are intended to be open-ended terms. Further, the phrase "based on" is intended to mean "based at least partially on" unless explicitly stated otherwise.

Non-limiting embodiments or aspects of the disclosed subject matter are directed to a heat management system, comprising: a ceramic body and a material having a higher thermal conductivity than the ceramic body and comprising a plurality of diamond particles, the material arranged in a network of channels defined in a surface of the ceramic body and/or forming an extension component attached to the ceramic body.

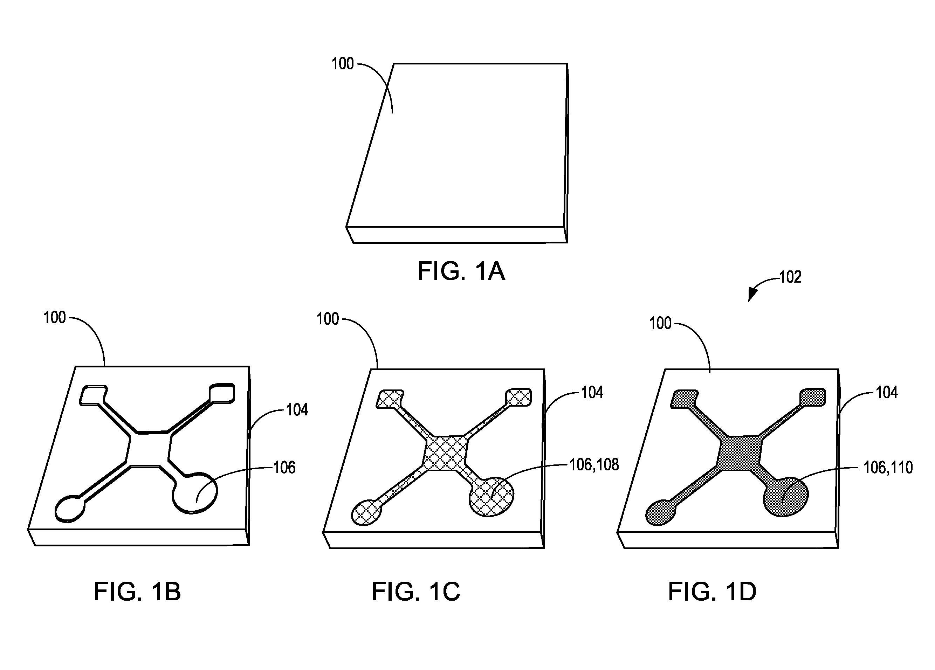

Referring to FIGS. 1A-1F, ceramic bodies being formed into a heat management system are shown according to some non-limiting embodiments or aspects.

FIG. 1A shows a ceramic body 100 from which a heat management system according to some non-limiting embodiments or aspects may be formed. The ceramic body 100 may be formed of a ceramic material. The ceramic material may be free of diamond. Non-limiting examples of the ceramic materials from which the ceramic body 100 may be formed include silicon carbide (SiC), boron carbide (B₄C), titanium diboride (TiB₂), or any combination thereof.

The ceramic body 100 may be modified to form a heat sink 104 as shown in FIGS. 1B-1F by defining channels 106 in a surface of the ceramic body 100 and/or by attaching an extension component 112 to the ceramic body 100. The ceramic body 100 is shown as having a square-shaped top view, but it will be appreciated that any suitable shape of the ceramic body 100 may be used.

As shown in FIG. 1B, a network of channels 106 may be defined in the surface of the ceramic body 100. The arrangement and dimensions of the network of channels 106 shown in FIG. 1B is non-limiting, and it will be appreciated that other arrangements and dimensions of channels 106 may be used in connection with the present disclosure. The arrangement of the channels 106 may refer to a number of channels 106 and/or a direction in which the channels 106 are defined and/or a shape of the channels 106 and/or an overall selection of the position of the channels 106 in the ceramic body 100. The dimensions of the channels 106 may refer to the length and/or width and/or depth of the channels 106. The arrangement and dimensions of the channels 106 in the ceramic body 100 may be selected to optimize the heat management capabilities as described hereinafter.

Referring to FIG. 1C, upon definition of the channels 106 in the ceramic body 100, the channels 106 may be filled with a preform material 108 comprising a plurality of diamond particles. The preform material 108 may be a powder material. The preform material 108 and/or the material formed therefrom may have a higher conductivity than the material from which the ceramic body 100 is made. The preform material 108 may have diamond particles and may additionally have ceramic particles and/or carbon particles. The preform material 108 may further comprise elemental silicon and/or boron.

Referring to FIG. 1D, the preform material 108 (from FIG. 1C) may be treated to form a reaction bonded material 110 (hereinafter "material 110"). The preform material 108 may be reaction bonded to form the material 110. The reaction bonding process may involve a reactive infiltration process applied to the preform material 108. The preform material 108 may be infiltrated with molten silicon, a silicon-aluminum alloy, a silicon-boron alloy, a silicon-titanium alloy, and/or the like to form the material 110. The molten material may react with the element carbon to form SiC and/or B₄C. The molten material may react with the surfaces of the diamond particles to produce diamond particles with reaction formed SiC and/or B₄C, thus forming a SiC-diamond and/or B₄C-diamond interface. The reaction formed SiC and/or B₄C may at least partially surround the diamond particles or may fully surround the diamond particles. The material 110 may further comprise elemental silicon and/or silicon alloy.

The diamond particles may have an average particle size ranging from 10-150 µm, such as from 20-150 µm or 50-150 µm. Average particle size may be determined by laser diffraction and/or sieving. The diamond particles may have an average particle size of at least 10 µm, such as at least 20 µm or at least 50 µm. The diamond particles may have an average particle size of up to 150 µm, such as up to 100 µm or up to 75 µm.

The diamond particles may comprise from 35-70 vol% of the material 110. The diamond particles may comprise at least 35 vol% of the material 110. The diamond particles may comprise up to 70 vol% of the material 110. The material 110 comprising 70 vol% diamond particles may be fabricated using a preform comprising up to 100 wt% diamond particles. The material comprising 35 vol% diamond may be fabricated using a preform comprising 50 wt% diamond particles and 50 wt% SiC powder. To achieve volume percents of diamond between 35 and 70, the weight percents of diamond particles and SiC powder may be adjusted accordingly.

The following table shows the effect of the amount of diamond (by vol%) in the material 110 on properties thereof.

| **Material (particle size)** | **Density (g/cc)** | **Young's Modulus (GPA)** | **CTE, 20-100°C (ppm/K)** | **Thermal Conductivity (W/mK)** |
|---|---|---|---|---|
| RB-SiC w/ 0% Diamond | 2.95 | 350 | 2.9 | 170 |
| RB-SiC w/ 35% Diamond (65 & 22 µm) | 3.25 | 560 | 1.6 | 420 |
| RB-SiC w/ 50% Diamond (65 µm) | 3.33 | 710 | 1.4 | 510 |
| RB-SiC w/ 70% Diamond (65, 22, & 10 µm) | 3.39 | 830 | 1.2 | 650 |

The material 110 may have a higher conductivity than the material from which the ceramic body 100 is made. In some non-limiting embodiments or aspects, the material 110 may have a thermal conductivity of at least 400 W/mK, such as at least 500 W/mK or at least 600 W/mK. Thermal conductivity may be determined by laser flash per ASTM 1461.

The material 110 may have a thermal expansion coefficient (CTE) ranging from 1.0 to 3.0 ppm/K. The material 110 may have a CTE of at least 1.0 ppm/K, such as at least 1.2 ppm/K, or at least 1.5 ppm/K. The material 110 may have a CTE of up to 3.0 ppm/K, such as up to 2.5 ppm/K or up to 2.0 ppm/K. Thermal expansion coefficient may be determined by dilatometry per ASTM E228.

The heat sink 104 shown in FIG. 1D may be a heat management system 102 as explained hereinafter.

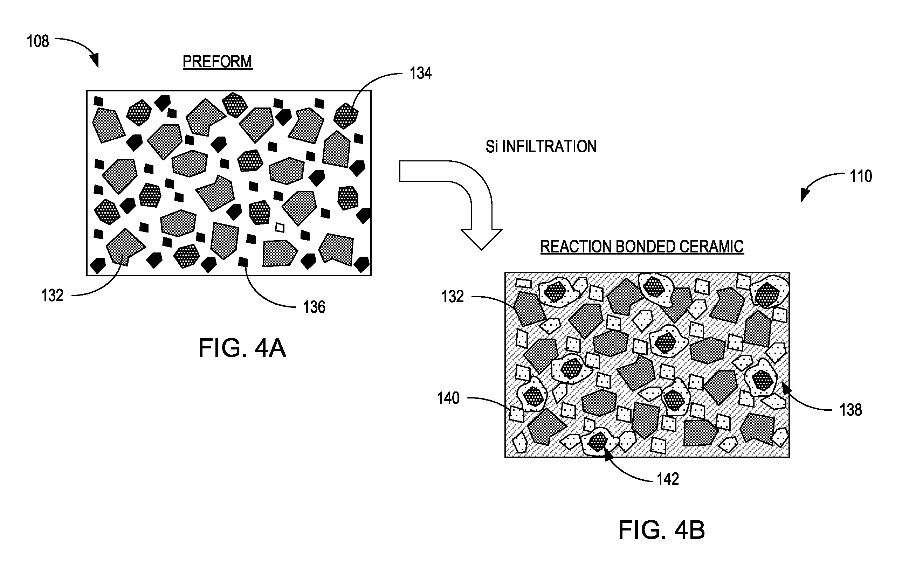

Referring to FIGS. 4A-4B a schematic diagram of the reaction bonding process described in connection with FIGS. 1C-1D is shown, according to some non-limiting embodiments or aspects.

FIG. 4A shows the preform material 108 (e.g., from FIG. 1C). The preform material 108 may comprise ceramic particles 132, diamond particles 134, and carbon particles. The ceramic particles 132 may comprise silicon carbide and/or boron carbide. The preform material 108 may further comprise residual elemental silicon and/or boron. The ceramic particles 132 may not comprise diamond.

FIG. 4B shows the material 110 (e.g., from FIG. 1D). The material 110 may be formed by applying the silicon (or alloy of silicon with aluminum, boron, titanium, and/or the like) infiltration process as described above. In the non-limiting example shown in 4B, molten silicon 138 may infiltrate the preform material 108 from FIG. 4A to form the material 110 in FIG. 4B. The molten silicon 138 may react with the carbon particles 136 to form reaction formed SiC particles 140. The molten silicon 138 may react with the surfaces of the diamond particles 134 to produce diamond particles with reaction formed SiC and/or B₄C 142. The material 110 may further comprise residual elemental silicon and/or silicon alloy.

The material 110 formed may exhibit the beneficial properties of having a low thermal expansion, a high thermal conductivity, a high hardness, a high wear resistance, a high stiffness, and/or a low coefficient of friction (e.g., compared to the material of the ceramic body). The material 110 may be difficult to machine (e.g., due to the diamond) such that it may be used in a selective manner in the manufacturing of the heat management system 102.

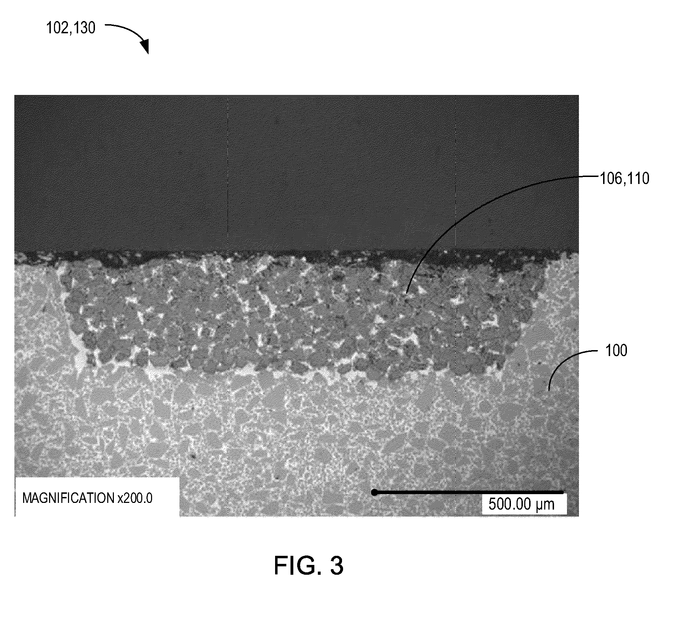

Referring to FIG. 3, a cross-sectional microscopic image 130 is shown of the heat management system 102 shown in FIG. 1D. The cross-sectional microscopic image 130 shows a channel 106 defined in the ceramic body 100, the channel 106 filled with the material 110.

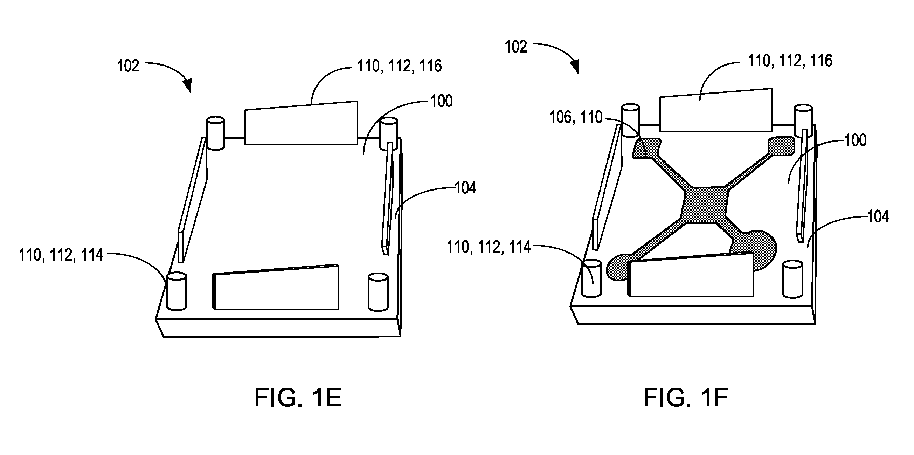

Referring to FIG. 1E, another non-limiting embodiment or aspect of a heat management system 102 is shown that is similar to FIG. 1D except that extension components 112 are used instead of channels 106. The extension component 112 may be a component separately formed from and attached to the ceramic body 100. The extension component 112 may be formed onto an existing ceramic body 100. The extension component 112 may be in the form of pins 114, fins 116, some combination thereof, or any other suitable shape of an extension component 112.

The extension component 112 may be formed from the material 110, such that the extension component 112 has a higher conductivity than the material from which the ceramic body 100 is made. The extension component 112 may be formed by preparing a preform of SiC and carbon, or SiC, diamond, and carbon for a higher thermal conductivity, having the desired shape of the extension component 112, followed by infiltrating the preform with the previously described molten material (e.g., molten silicon and/or silicon alloy) to form a SiC and Si composite made of the original SiC, reaction formed SiC (Si + C → SiC), and residual Si. Thus, the shape of the extension component 112 may be formed in the preform prior to the Si infiltration process.

Referring to FIG. 1F, another non-limiting embodiment or aspect of a heat management system 102 is shown. The heat management system 102 of FIG. 1F combines features from FIGS 1D and 1E, in that the heat management system 102 includes both channels 106 defined in the surface of ceramic body 100 filled with the material 110 and an extension component 112 formed from the material 110 attached to the ceramic body 100.

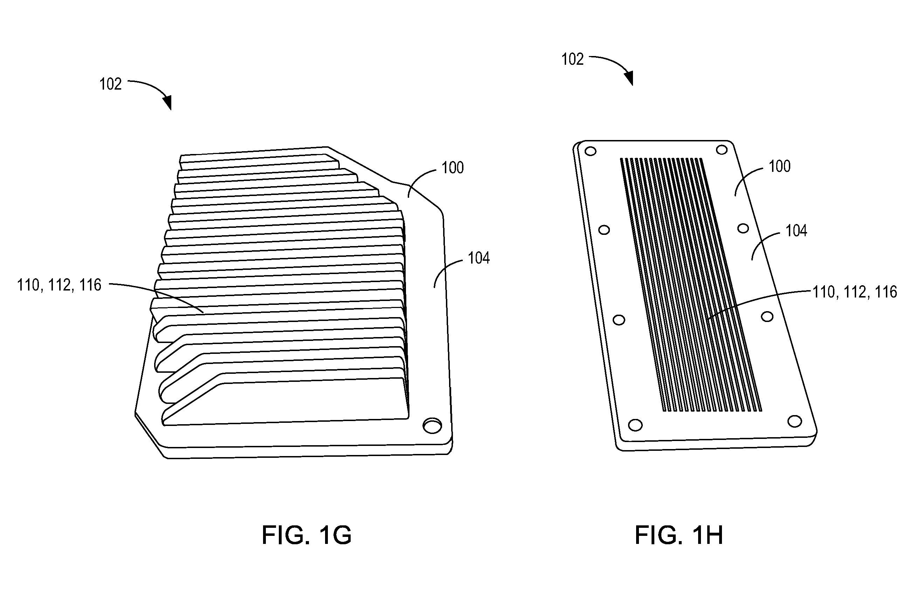

Referring to FIG. 1G, another non-limiting embodiment or aspect of a heat management system 102 is shown. The heat management system 102 of FIG. 1G may include a plurality of extension components 112 in the form of fins 116 formed from the material 110 protruding from the body 100.

Referring to FIG. 1H, another non-limiting embodiment or aspect of a heat management system 102 is shown. The heat management system 102 of FIG. 1H may include a plurality of extension components 112 in the form of fins 116 formed from the material 110 embedded in line with the body 100.

Referring to FIGS. 1D-1F, the material 110 filling the channels 106 and/or forming the extension component 112 being more thermally conductive than the material of the ceramic body 100 enhances the heat management system's 102 ability to more quickly dissipate (also referred to herein as "transfer", "disperse", "spread") heat experienced in one or more regions of the ceramic body 100 compared to a ceramic body not including the material 110. The heat management system 102 may dissipate heat experienced in one or more regions of the ceramic body 100 by spreading heat throughout the heat sink 104 more evenly by the material 110 conducting the heat more efficiently than the material of the ceramic body 100 (e.g., based on the comparative thermal conductivity of these materials). Due to the increased costs and difficulty in processing the heat sink 104 using a material including diamond particles, the arrangement of the material 110 including the diamond particles may be strategically selected to balance the desired increase in thermal conductivity with the difficulties in processing materials comprising the diamond particles.

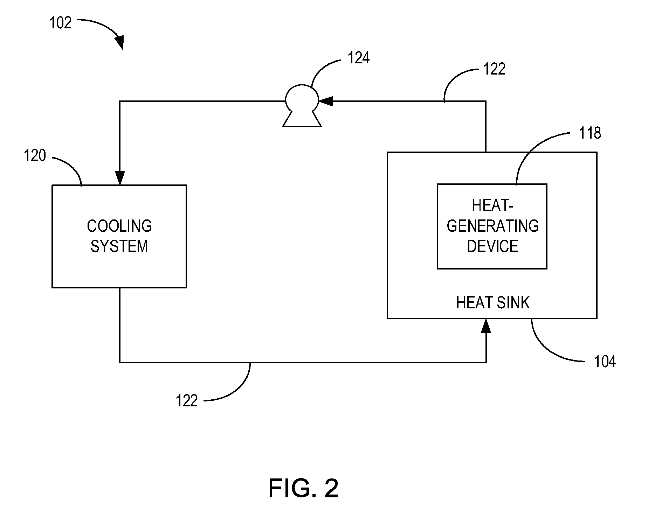

Referring to FIG. 2, a heat-generating device 118 having a heat management system 102 is shown according to some non-limiting embodiments or aspects. The heat-generating device 118 may generate heat while in use. For example, the heat-generating device 118 may comprise a computing device and/or a component thereof. The heat-generating device 118 may comprise an electronic component and/or a component of a laser system.

With continued reference to FIG. 2, the heat sink 104 may be arranged proximate to the heat-generating device 118. For example, the heat sink 104 may be arranged attached to (e.g., in direct contact with) the heat-generating device 118, such as attached to the region of the heat-generating device 118 that generates heat while in use. The heat sink 104 may include any configuration of the heat sinks 104 as described herein, such as those shown and described in FIGS. 1D-1F.

The heat management system 102 may be configured to efficiently and/or quickly dissipate the heat generated by the heat-generating device 118 using the heat sink 104. For example, the material 110 in the channels 106 and/or forming the extension component 112 in the heat sinks in FIGS. 1D-1F may more quickly dissipate the heat generated by the heat-generating device 118 based on the higher thermal conductivity of the material 110 compared to ceramic body 100.

Referring to FIGS. 1D-1F and FIG. 2, the arrangement of the channels 106 filled with the material 110 and/or the extension component 112 formed from the material 110 may be selected to efficiently and/or quickly dissipate the heat generated by the heat-generating device 118. In some non-limiting embodiments or aspects, the heat may be selectively dissipated in one or more directions based on a predetermined desired heat profile. A heat profile may comprise a directional and/or temporal summary of heat transfer by the heat sink 104, such as a direction of heat transfer, a rate of heat transfer, a time it takes to transfer at least a portion of the heat, and the like, or any combination thereof.

For example, the channels 106 and/or the extension component 112 may be arranged to transfer the heat generated by the heat-generating device 118 in a predetermined direction parallel to the surface of the ceramic body 100 (e.g., in an x- and/or y-direction relative to the surface). The number and arrangement of the channels 106 may be designed to achieve the desired heat profile (e.g., to transfer the heat in the desired direction). The arrangement of channels 106 may refer to a direction in which the channels 106 may be extended in one or more directions parallel to the surface of the ceramic body 100, the distance the channels are extended in a given direction, the width of the channels, and the like.

For example, the channels 106 and/or the extension component 112 may be arranged to transfer the heat generated by the heat-generating device 118 in a predetermined direction parallel to the surface of the ceramic body 100 (e.g., in an x- and/or y-direction relative to the surface). The number of channels 106 and/or extension components 112, the direction of extension of channels 106 and/or extension components 112 parallel to the surface of the ceramic body 100, the distance the channels 106 and/or extension components 112 travel in a given direction, the width of the channels 106 and/or extension components 112, the shape of the channels 106 and/or extension components 112, and the like may be designed to achieve the desired heat profile (e.g., to transfer the heat in the desired x- or y-direction).

The heat-generating device 118 may generate heat, and the heat sink 104 may be arranged proximate to (e.g., near and/or in contact with) the source of the heat generated by the heat-generating device 118. In some non-limiting embodiments or aspects, the heat generated by the heat-generating device 118 may heat one or more points of the ceramic body 100 of the heat sink 104. The heat sink 104 may comprise a first region closer to the heat source of the heat-generating device 118 and a second region farther from the heat source of the heat-generating device 118. The regions may be different spatial locations at or near the surface of the heat sink 104. A desired heat profile for the heat sink 104 may be achieved by transferring heat from the heat source of the heat-generating device 118 from the first region to the second region. The heat may be transferred to spread the heat faster across the heat sink 104 (e.g., a surface thereof, a depth thereof, or any combination thereof). The heat may be transferred to a predetermined region of the heat sink 104 (e.g., to the second region or a portion of the second region). Heat from the heat source of the heat-generating device 118 may be transferred parallel to the surface of the ceramic body 100 by arranging channels 106 and/or extension components 112 extending from the first region to the second region, as the channels 106 and/or extension components 112 containing the material 110 may transfer heat more efficiently and/or quickly than the material of the ceramic body 100.

For example, the channels 106 and/or the extension component 112 may be arranged to transfer the heat generated by the heat-generating device 118 in a predetermined direction perpendicular to the surface of the ceramic body 100 (e.g., in a z-direction relative to the surface). The number and arrangement of the channels 106 and/or the extension components 112 may be extended in one or more directions perpendicular to the surface of the ceramic body 100, and the depth the channels 106 and/or extension components 112 travel in a z-direction, the shape of the channels 106 and/or extension components 112, and the like may be designed to achieve the desired heat profile (e.g., to transfer the heat in the desired z-direction).

The heat-generating device 118 may generate heat, and the heat sink 104 may be arranged proximate to (e.g., near and/or in contact with) the source of the heat generated by the heat-generating device 118. In some non-limiting embodiments or aspects, the heat generated by the heat-generating device 118 may heat one or more points of the ceramic body 100 of the heat sink 104. The heat sink 104 may comprise a first region closer to the heat source of the heat-generating device 118 and a second region farther from the heat source of the heat-generating device 118. The regions may be different spatial locations at different depths of the heat sink 104. A desired heat profile for the heat sink 104 may be achieved by transferring heat from the heat source of the heat-generating device 118 from the first region to the second region. The heat may be transferred to spread the heat faster across the heat sink 104 (e.g., a surface thereof, a depth thereof, or any combination thereof). The heat may be transferred to a predetermined region of the heat sink 104 (e.g., to the second region or a portion of the second region). Heat from the heat source of the heat-generating device 118 may be transferred perpendicular to the surface of the ceramic body 100 by arranging channels 106 and/or extension components 112 extending from the first region to the second region, as the channels 106 and/or extension components 112 containing the material 110 may transfer heat more efficiently and/or quickly than the material of the ceramic body 100.

With continued reference to FIGS. 1D-1F and FIG. 2, in some non-limiting embodiments or aspects, an amount of the diamond particles in the material 110 by vol% may vary along the network of channels 106 and/or the extension component 112. For example, a first region of the network of channels 106 and/or the extension component 112 closer to the heat source of the heat-generating device 118 may have a higher concentration of diamond particles making up the material 110 compared to a second region of the network of channels 106 and/or the extension component 112 farther from the heat source of the heat-generating device 118. The selective arrangement of a higher concentration of diamond particles closer to the heat source may enable the heat sink 104 to more efficiently and/or quickly spread the heat from the heat source of the heat-generating device 118 to cooler regions of the heat sink 104.

With continued reference to FIGS. 1D-1F and FIG. 2, in some non-limiting embodiments or aspects, the heat sink 104 may comprise a first region closer to the heat source of the heat-generating device 118 and a second region farther from the heat source of the heat-generating device 118. The first region of the heat sink 104 may have a higher concentration of the material 110 compared to the second region. The higher concentration of the material 110 in the first region may enable the heat sink 104 to more efficiently and/or quickly spread the heat from the heat source of the heat-generating device 118 to cooler regions of the heat sink 104. This may be due to the increased thermal conductivity of the material 110 compared to the material of the ceramic body 100.

With continued reference to FIGS. 1D-1F and FIG. 2, in some non-limiting embodiments or aspects, the heat sink 104 may comprise a first region closer to the heat source of the heat-generating device 118 and a second region farther from the heat source of the heat-generating device 118. The second region may comprise a predetermined region to which heat generated by the heat-generating device 118 is to be transferred (e.g., based on a predetermined desired heat profile). At least one channel 106 and/or at least one extension component 112 may run from the first region to the second region. The material 110 of the least one channel 106 and/or the at least one extension component 112 may enable the heat sink 104 to more efficiently and/or quickly spread the heat from the heat source of the heat-generating device 118 to the predetermined second region.

With continued reference to FIGS. 1D-1F and FIG. 2, in some non-limiting embodiments or aspects, the network of channels 106 may be arranged in the ceramic body 100 and have the material 110 therein and/or the extension component having the material 110 may be arranged such that heat from a heat source of the heat-generating device 118 (e.g., a point heat source) applied to a section of the ceramic body 100 is transferred faster across the surface of the ceramic body. Faster heat transfer may be achieved by the heat management system 102 of the present disclosure compared to the same ceramic body 100 not comprising the network of channels 106 comprising the material 110 and/or the extension component having the material 110 because of the very high thermal conductivity of the diamond-containing channels 106 or extension component 112 as compared to the base material of the ceramic body 100.

With continued reference to FIGS. 1D-1F and FIG. 2, in some non-limiting embodiments or aspects, the heat management system 102 may further comprise a cooling system 120. The cooling system 120 may be in fluid communication with the heat sink 104 to cool the heat sink 104. The heat management system 102 may have a network of pipes 122 that place the cooling system 120 in fluid communication with the heat sink 104 and/or a pump 124 to pump fluid through the network of pipes.

The cooling system 120 may comprise at least one cooling fluid having a temperature lower than the temperature of the heat sink 104 that has spread heat generated by the heat-generating device 118. The cooling fluid may comprise water or any other coolant having a sufficiently low temperature compared to the temperature of the heat sink 104 that has spread heat generated by the heat-generating device 118. The cooling fluid may comprise a liquid coolant.

Cooling fluid from the cooling system 120 may be pumped by the pump 124 through the network of pipes 122 to the heat sink 104 to function as a heat exchanger with the heat sink 104. Heat from the heat sink 104 may be transferred to the cooling fluid flowing past the heat sink 104, thus reducing the temperature of the heat sink 104 and increasing the temperature of the cooling fluid. The cooling fluid may be in direct contact with the heat sink 104 and/or the cooling fluid may be in indirect contact with the heat sink 104. The cooling fluid to which at least a portion of the heat from the heat sink 104 has been transferred may be pumped by the pump 124 from the heat sink 104 through the network of pipes 122 back to the cooling system 120.

The cooling fluid may cool the entire heat sink 104 or cool a predetermined region thereof. In embodiments in which the cooling fluid cools a predetermined region of the heat sink 104, the network of channels 106 may be arranged in the ceramic body 100 and have the material 110 therein and/or the extension component 112 having the material 110 may be arranged to selectively transfer heat to the region of the heat sink 104 cooled by the cooling fluid. In this way, the network of channels 106 and/or the extension component 112 may transfer heat to the cooling system 120. The heat may be preferentially transferred by the network of channels 106 and/or the extension component 112 to the region of the heat sink 104 configured to further transfer the heat away via the cooling fluid and to the cooling system 120.

Referring again to FIGS. 1A-1F, the heat management system 102 may be manufactured as follows.

A heat management system 102 having a network of channels 106 may be manufactured. The ceramic body 100 as shown in FIG. 1A may be provided. A network of channels 106 may be defined in the surface of the ceramic body 100 (see FIG. 1B). The network of channels 106 may be defined in the surface of the ceramic body 100 using any suitable technique, such as by laser machining, traditional machining (e.g., milling), molding, and the like. As shown in FIG. 1C, the preform material 108 may be arranged in the network of channels 106. As shown in FIG. 1D, the preform material 108 may be reaction bonded (e.g., by the silicon or boron reactive infiltration process) to form the material 110. The preform material 108 may comprise silicon carbide and/or boron carbide compositions surrounding the diamond particles, and the reaction bonding process may comprise treating the preform material 108 such that silicon and/or boron reacts with the diamond particles to form a SiC or B₄C interface to form the material 110. The material 110 may have a higher thermal conductivity than the material of the ceramic body 100 removed to form the channels 106.

A heat management system 102 having an extension component 112 may be manufactured. The ceramic body 100 as shown in FIG. 1A may be provided. An extension component 112 may be attached to the ceramic body 100. The extension component 112 may be formed and/or attached to the ceramic body using any suitable technique. The extension component 112 may be formed from the material 110, such that the extension component 112 has a higher conductivity than the material from which the ceramic body 100 is made. The extension component 112 may be formed by preparing a preform of SiC and carbon, or SiC, diamond, and carbon for a higher thermal conductivity, having the desired shape of the extension component 112, followed by infiltrating the preform with the previously described molten material (e.g., molten silicon and/or silicon alloy) to form a SiC and Si composite made of the original SiC, reaction formed SiC (Si + C → SiC), and residual Si. The preform material 108 may comprise silicon carbide and/or boron carbide compositions surrounding the diamond particles, and the reaction bonding process may comprise treating the preform material 108 such that silicon and/or boron reacts with the diamond particles to form a SiC or B₄C interface to form the material 110. As shown in FIG. 1E, the extension component 112 formed from the material 110 may be attached to the ceramic body 100. The material 110 from which the extension component 112 is formed may have a higher thermal conductivity than the material of the ceramic body 100.

### EXAMPLES

The following examples are presented to demonstrate the general principles of the disclosure. The disclosure should not be considered as limited to the specific examples presented.

### Example 1

### Point Heat Source Applied to Heat Management System Comprising Channels Filled with a Material Comprising Diamond Particles with Reaction formed Silicon Carbide

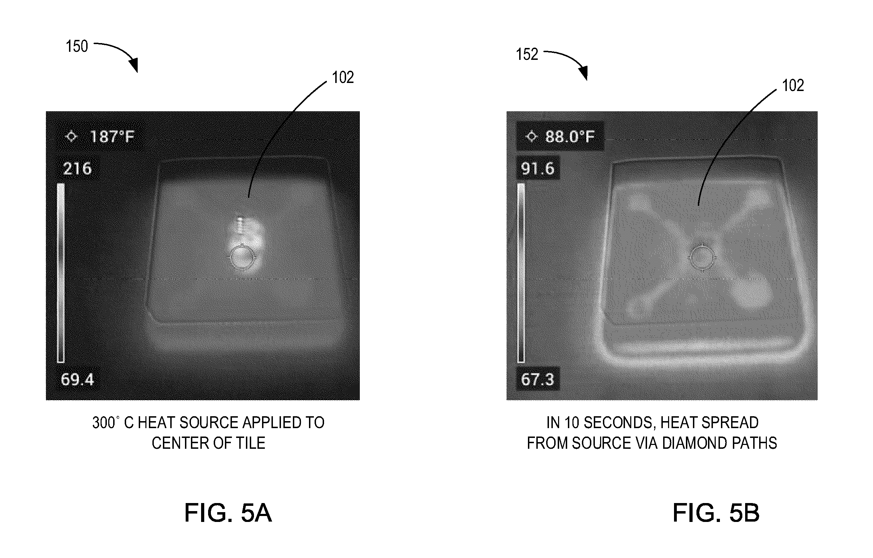

A tile heat management system 102 was prepared that included a silicon carbide ceramic body having a network of channels as shown in FIGS. 5A-5B, with the channels filled with a material comprising diamond particles with reaction formed silicon carbide as described herein. FIGS. 5A-5B show infrared images 150,152 of the tile heat management system 102 at two different times.

In FIG. 5A, the infrared image 150 shows time t=0 of a point heat source being applied to the center of the tile heat management system 102 at 300°C.

In FIG. 5B, the infrared image 152 shows time t=10 seconds of the point heat source being applied to the center of the tile heat management system 102 at 300°C. As can be seen in the infrared image 152, at 10 seconds, the heat from the point heat source is spread from the location of the point heat source across the ceramic body via the channels filled with the diamond particles with reaction formed silicon carbide.

### Examples 2-3

### Point Heat Source Applied to Heat Management System Comprising Channels Filled with a Material Comprising Silicon Carbide (No Diamond) and a Material Comprising Diamond Particles with Reaction formed Silicon Carbide

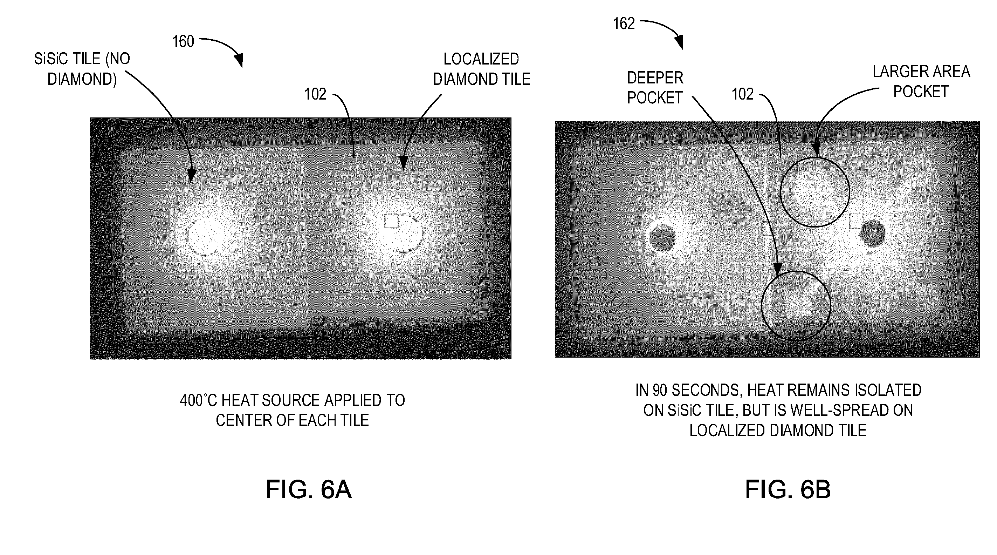

The tile heat management system of Comparative Example 2 was prepared that included a silicon carbide ceramic body, which is shown as the left tile in FIGS. 6A-6B. The tile heat management system 102 of inventive Example 3 was prepared that included a silicon carbide ceramic body having a network of channels as shown in FIGS. 6A-6B (right tiles), with the channels filled with a material comprising diamond particles with reaction formed silicon carbide as described herein. FIGS. 6A-6B show infrared images 160,162 of the tile heat management system 102 at two different times, with the left tile in each showing Comparative Example 2 and the right tile in each showing Example 3.

In FIG. 6A, the infrared image 160 shows time t=0 of a point heat source being applied to the center of the tiles at 400°C.

In FIG. 6B, the infrared image 162 shows time t=90 seconds of the point heat source being applied to the center of the tiles at 400°C. As can be seen in the infrared image 162, at 90 seconds, the heat from the point heat source in Comparative Example 2 remains relatively isolated on the silicon carbide tile, whereas the heat is well-spread across the heat management system 102 Example 3. Moreover, the channels in Example 3 include a larger pocket area to more quickly spread heat in a direction parallel to the surface (compared to the material of the ceramic body), and the channels also include a deeper pocket area to more quickly spread heat in a direction perpendicular to the surface (compared to the material of the ceramic body). Therefore, the selective use of the channels filled with the diamond particles with reaction formed silicon carbide improve the efficiency of the heat management system 102.

Although the disclosed subject matter has been described in detail for the purpose of illustration based on what is currently considered to be the most practical and preferred embodiments or aspects, it is to be understood that such detail is solely for that purpose and that the disclosed subject matter is not limited to the disclosed embodiments or aspects, but, on the contrary, is intended to cover modifications and equivalent arrangements that are within the spirit and scope of the appended claims. For example, it is to be understood that the presently disclosed subject matter contemplates that, to the extent possible, one or more features of any embodiment or aspect can be combined with one or more features of any other embodiment or aspect.

## Claims

1. A heat management system, comprising:
a ceramic body; and
a material having a higher thermal conductivity than the ceramic body and comprising a plurality of diamond particles,
the material arranged in a network of channels defined in a surface of the ceramic body and/or forming an extension component attached to the ceramic body.

2. The heat management system of claim 1, wherein the ceramic body comprises a silicon carbide and/or a boron carbide body.

3. The heat management system of claim 1 or claim 2, wherein the material comprises a reaction-bonded silicon carbide and/or boron carbide composition surrounding the diamond particles, optionally wherein silicon and/or boron is reacted with the diamond particles to form a SiC or B₄C interface.

4. The heat management system of claim 3 or claim 4, wherein the material further comprises elemental silicon and/or boron.

5. The heat management system of any preceding claim, wherein the diamond particles have an average particle size ranging from 10-150 µm.

6. The heat management system of any preceding claim, wherein the diamond particles comprise 35-70 vol% of the material.

7. The heat management system of any preceding claim, wherein the material comprises a thermal conductivity of at least 400 W/mK.

8. The heat management system of any preceding claim, wherein the material comprises a thermal expansion coefficient (CTE) ranging from 1.0 to 3.0 ppm/K.

9. The heat management system of any preceding claim, wherein an arrangement of the network of channels and/or the extension component is selected to transfer heat encountered by the heat management system in a predetermined direction parallel to the surface.

10. The heat management system of any preceding claim, wherein a depth of the network of channels and/or an arrangement of the extension component is selected to transfer heat encountered by the heat management system in a predetermined direction perpendicular to the surface.

11. The heat management system of any preceding claim, wherein an amount of the diamond particles in the material by vol% varies along the network of channels and/or the extension component.

12. The heat management system of any preceding claim, further comprising a component that generates heat proximately arranged relative to the ceramic body,
wherein the ceramic body comprises a first region closer to the component than a second region of the ceramic body, wherein the first region comprises a higher concentration of the material compared to the second region.

13. The heat management system of any preceding claim, comprising a component that generates heat proximately arranged relative to the ceramic body,
wherein the ceramic body comprises a first region closer to the component than a second region of the ceramic body, wherein the second region is a predetermined region to which heat generated by the component is to be transferred, wherein a channel of the network of channels comprising the material and/or the extension component having the material runs from the first region to the second region.

14. The heat management system of any preceding claim, further comprising a component that generates heat proximately arranged relative to the ceramic body, wherein the component comprises a component of a computing device.

15. The heat management system of any preceding claim, wherein the network of channels are arranged in the ceramic body and have the material therein and/or the extension component having the material is arranged such that heat from a point heat source applied to a point along the ceramic body is transferred across the surface of the ceramic body faster compared to the same ceramic body not comprising the network of channels comprising the material and/or the extension component having the material.

16. The heat management system of any preceding claim, further comprising:
a cooling system,
wherein a channel of the network of channels and/or the extension component transfers heat to the cooling system.

17. A method of manufacturing a heat management system, comprising:
defining a network of channels in a surface of a ceramic body and/or attaching an extension component to the ceramic body;
arranging a material having a higher thermal conductivity than the ceramic body in the network of channels and/or the extension component is formed from the material, the material comprising a plurality of diamond particles
and optionally further comprising:
reaction bonding the material in the network of channels and/or to form the extension component.

18. The method of claim 17, wherein the material comprises silicon carbide and/or boron carbide compositions surrounding the diamond particles, and the reaction bonding the material comprises treating the material such that silicon and/or boron reacts with the diamond particles to form a SiC or B₄C interface.

19. A computing device comprising the heat management system of any of claims 1 to 16.
